(19) Europäisches Patentamt / European Patent Office / Office européen des brevets

(11) **EP 4 508 455 B1**

## (12) EUROPEAN PATENT SPECIFICATION

(45) Date of publication and mention
of the grant of the patent:
**10.06.2026 Bulletin 2026/24**

(21) Application number: **23716898.4**

(22) Date of filing: **06.04.2023**

(51) International Patent Classification (IPC):
*G01R 33/48* (2006.01)          *G01R 33/54* (2006.01)
*G01R 33/561* (2006.01)        *G01R 33/44* (2006.01)
*G01R 33/485* (2006.01)       *G01R 33/565* (2006.01)

(52) Cooperative Patent Classification (CPC):
**G01R 33/4818; G01R 33/543; G01R 33/561;**
G01R 33/443; G01R 33/4828; G01R 33/485;
G01R 33/56545; G01R 33/56554

(86) International application number:
**PCT/EP2023/059186**

(87) International publication number:
**WO 2023/198608 (19.10.2023 Gazette 2023/42)**

(54) **MR IMAGING USING PARTIAL ECHO ACQUISITION**

MR-BILDGEBUNG MITTELS PARTIELLER ECHOERFASSUNG

IMAGERIE PAR RÉSONANCE MAGNÉTIQUE UTILISANT UNE ACQUISITION D'ÉCHO PARTIELLE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **15.04.2022 EP 22168641**

(43) Date of publication of application:
**19.02.2025 Bulletin 2025/08**

(73) Proprietor: **Koninklijke Philips N.V.
5656 AE Eindhoven (NL)**

(72) Inventor: **EGGERS, Holger
5656 AG Eindhoven (NL)**

(74) Representative: **Philips Intellectual Property &
Standards
High Tech Campus 52
5656 AG Eindhoven (NL)**

(56) References cited:
• **BYDDER MARK ET AL: "Minimizing echo and
repetition times in magnetic resonance imaging
using a double half-echo k-space acquisition and
low-rank reconstruction", NMR IN
BIOMEDICINE., vol. 34, no. 4, 9 December 2020
(2020-12-09), GB, pages 1 - 8, XP055886032,
ISSN: 0952-3480, DOI: 10.1002/nbm.4458**

**Description**

FIELD OF THE INVENTION

The invention relates to the field of magnetic resonance (MR) imaging. It concerns a method of MR imaging of an object placed in the examination volume of an MR system. The invention also relates to an MR system and to a computer program to be run on an MR system.

BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

In MR imaging, fractional sampling of k-space along the readout (frequency-encoding) direction, herein referred to as partial echo (PE) acquisition, is a well-known strategy for reducing the echo time (TE), see M. Bydder et al. in NMR in Biomedicine, 2021; 34:e4458. This is useful for acquiring MR signals from short $T_2$ species but also reduces the repetition time (TR) and, if applicable, the inter-echo spacing of the used imaging sequence. PE sampling is of particular interest in magnetic resonance angiography (MRA) to mitigate signal loss induced by flow.

In theory, partial Fourier (PF) methods such as PE acquisition allow sampling only one half of k-space. The other half of k-space is synthesized in reconstruction under the assumption of conjugate symmetry, which only holds for real (as opposed to complex) MR signals in image space. Reconstruction by simple Fourier transform is not advisable from PE sampling. However, various algorithms have been developed to produce relatively artifact-free images based on the assumption that there is smooth phase variation across the images. In practice, the PE sampling is slightly extended to fully cover the central k-space region and thus to capture low-frequency phase variation.

PE methods are fundamentally limited by the missing k-space data, which prevent recovering the high-frequency phase variation and cause signal loss. Acceleration methods, such as parallel imaging (PI) and compressed sensing (CS), are in general unable to compensate for this deficiency, mainly due to the large size of the continuous k-space area spared by the incomplete sampling.

Bydder M. et al., "Minimizing echo and repetition times in magnetic resonance imaging using a double half-echo k-space acquisition and low-rank reconstruction", NMR IN BIOMEDICINE, vol. 34, no. 4, p.1-8 (2020) describes a method for reconstructing images from exact half echoes using two separate acquisitions with reversed readout polarity, effectively providing a full line of k-space without additional data around central k-space.

SUMMARY OF THE INVENTION

It is an object of the invention to provide a method that enables improved MR imaging using PE acquisition.

In accordance with the invention, a method of MR imaging of an object placed in an examination volume of an MR system is provided as defined in claim 1.

The method comprises the following steps:

- subjecting the object to an imaging sequence comprising a series of RF excitations, wherein an echo signal is generated in the presence of a readout magnetic field gradient in each repetition time interval between successive RF excitations, wherein phase-encoding magnetic field gradients are switched in each repetition time interval to sample a pre-defined region of k-space;
- acquiring the echo signals from the object as partial echoes with different readout polarities, each echo signal being associated with either a first direction of the readout magnetic field gradient or a second direction of the readout magnetic field gradient which is opposite to the first direction, wherein the echo signals associated with the first and/or the second direction sample k-space sparsely in at least one phase-encoding direction; and
- reconstructing an MR image from the acquired echo signals.

The invention proposes to acquire PE readouts with two gradient polarities in opposite directions, i.e. a bipolar PE acquisition. Previously, two PE readouts with gradient polarities in opposite directions and identical phase encoding have been combined to obtain one (virtual) full echo (FE) readout. In this way, a complete sampling of k-space along the readout direction has been obtained, with the short TE of the PE acquisition, but only in almost twice the acquisition time, see M. B. Scheidegger et al. in Magnetic Resonance Imaging 1991; 9:517-524. The invention proposes that the PE readouts with positive and negative gradient polarity each sample k-space sparsely in at least one of the phase-encoding directions. Sparse sampling in the phase-encoding direction means that the sampling density in the phase-encoding direction is sparse compared to that required by the Nyquist criterion according to the imaged field of view (FOV). The invention also proposes that the PE readouts with positive and negative polarity do not necessarily share the same phase encoding. Not the same phase encoding means that the PE readouts with positive and negative polarity do not only cover k-space differently along the readout direction, but also in at least one of the phase-encoding directions.

In an embodiment of the invention, the echo signals associated with the first readout direction sample a sub-region of k-space that is not sampled by the echo signals associated with the second readout direction, and vice versa. In other words, the k-space area that is spared by the echo signals associated with the first readout direction is covered by the echo signals associated with the second readout direction. The invention thus achieves a synthesis of the missing k-space data without the assumption that there is smooth phase variation across the image. For this purpose, the invention proposes to apply strategies known as such in the art for reconstructing artifact-free images from sparsely sampled k-space data, such as sensitivity encoding (SENSE), compressed sensing (CS), and combinations thereof, for the synthesis of the missing k-space data, instead of conventional PE strategies.

In a further embodiment, the k-space regions sampled by the echo signals associated with the first and second directions, respectively, overlap in a central part of k-space. In another embodiment, the echo signals associated with the first and second directions, taken in combination, sample k-space fully in a central part. In even another embodiment, they sample k-space in an interleaved pattern in the at least one phase-encoding direction. This results in a higher sampling density, or even full sampling, in the k-space center, but still without increasing TE or the overall acquisition time compared to conventional PE methods.

Reversing the readout direction during the acquisition causes distortions induced by main magnetic field inhomogeneity to change direction. These distortions can be addressed by adding the step of mapping the main magnetic field inhomogeneity, wherein the main magnetic field inhomogeneity is taken into account in the step of reconstructing the MR image. Alternatively, the distortions can be estimated from the two sparsely sampled individual data sets (one associated with the first readout direction, the other associated with the second readout direction), requiring a separate intermediate reconstruction of both and the application of a registration to the resulting intermediate MR images.

Similarly, reversing the readout direction during the acquisition potentially causes linear and higher order gradient fields to change. These changes can be addressed by mapping a spatially or spatiotemporally varying phase difference between the echo signals associated with the first and the second direction, respectively, wherein the phase difference is taken into account in the step of reconstructing the MR image. This phase difference can again be estimated from the two sparsely sampled individual data sets, requiring a separate intermediate reconstruction of both, or from separate measurements.

Moreover, reversing the readout gradient during the acquisition potentially alters the integral of the readout gradient from TR to TR. In a further embodiment, a spoiler magnetic field gradient in the readout direction, applied after acquiring the echo signals, is adapted in the imaging sequence such that this integral stays the same from TR to TR. In this way, a steady-state spoiling regime can be preserved, for example.

In non-contrast-enhanced cerebral MRA, a TE for which the MR signals from water and from fat have an opposed phase is often favored. However, this results in a low scan efficiency of the employed gradient-echo sequence, in particular at 1.5 T, while only providing a poor fat suppression. In a further embodiment, a TE is chosen for which the MR signals from water and from fat are approximately in quadrature, i.e. have a phase difference of $\pm 90°$, and a one-point Dixon method is applied, known as such in the art for separating MR signals from water and from fat from echo signals acquired at a single TE.

Using a two-point Dixon method, or dual-acquisition Dixon imaging, principally promises a better fat suppression and permits shortening the TE further, but usually involves introducing dead times to shift the readout magnetic field gradient for chemical shift encoding, which again negatively affects the scan efficiency. Hence, according to a further aspect, the invention proposes that the echo signals are acquired at different TEs, each echo signal being associated with either a first TE or a second TE so that a chemical shift encoding is applied to the acquired echo signals, wherein contributions from water and fat are then separated in the step of reconstructing the MR image according to a (as such known) two-point Dixon method. The invention thus proposes combining dual-acquisition Dixon imaging with bipolar PE acquisition. In this way, the invention allows enhancing image quality by shortening the TE, eliminating the fat signal, avoiding partial echo artifacts, and increasing the signal-to-noise ratio (SNR).

In order to improve the scan efficiency of the resulting gradient-echo imaging sequences, the strength of the readout magnetic field gradient applied during acquisition of the echo signals associated with the shorter of the two TEs can be made smaller than the strength of the readout magnetic field gradient applied during acquisition of the echo signals associated with the longer of the two TEs. Furthermore, the partial echo factor (PEF) can be adapted to maximize the acquisition time under the constraints imposed by the phase-encoding magnetic field gradients. Alternatively or additionally, the spoiler readout magnetic field gradient with the larger area is associated with the shorter TE. That is, the area of the spoiler readout magnetic field gradient associated with the shorter echo time is larger than the spoiler readout magnetic field gradient's area associated with the longer echo time.

The reconstruction of an MR image from conventional PE methods, or conventional PF methods in general, usually involves a weighting of the acquired echo signals in k-space, a Fourier transform, and optionally a phase correction and subsequent elimination of the imaginary part in image space. The weighting addresses the truncation of the echo signals in k-space and suppresses the otherwise occurring (Gibbs) ringing artifacts. For example, a simple Hanning window filter may be used as a weighting, which varies smoothly from zero to one over an appropriately chosen distance in k-space.

The methods of the invention described thus far can be carried out by means of an MR system including at least one main magnet coil for generating an essentially uniform, static magnetic field $B_0$ within an examination volume, a number of gradient coils for generating switched magnetic field gradients in different spatial directions within the examination volume, at least one body RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstructing MR images from the received MR signals. The methods of the invention can be implemented by a corresponding programming of the reconstruction unit and/or the control unit of the MR system.

The methods of the invention can be advantageously carried out on most MR systems in clinical use at present. To this end it is merely necessary to utilize a computer program by which the MR system is controlled such that it performs the above-explained method steps of the invention. The computer program may be present either on a data carrier or be present in a data network so as to be downloaded for installation in the control unit of the MR system.

BRIEF DESCRIPTION OF THE DRAWINGS

The enclosed drawings disclose preferred embodiments of the present invention as well as an example outside the scope of the present invention. It should be understood, however, that the drawings are designed for the purpose of illustration only and not as a definition of the limits of the invention. In the drawings:

Fig. 1 shows an MR system for carrying out the method of the invention;
Fig. 2a shows a diagram of k-space of a conventional partial Fourier acquisition
Figs. 2b, 2c shows respective diagrams of k-space illustrating examples of the bipolar readout strategy of the invention;
Fig. 3 shows a schematic (simplified) pulse sequence diagram according to a first embodiment of the invention;
Fig. 4 shows a schematic (simplified) pulse sequence diagram according to a second embodiment of the invention;
Fig. 5 shows a schematic (simplified) pulse sequence diagram according to a third embodiment of the invention;
Fig. 6 shows a schematic (simplified) pulse sequence diagram according to a fourth embodiment of the invention;
Fig. 7 shows MR images illustrating another aspect of a PF method according to an example outside the scope of the present invention.

DETAILED DESCRIPTION OF THE EMBODIMENTS

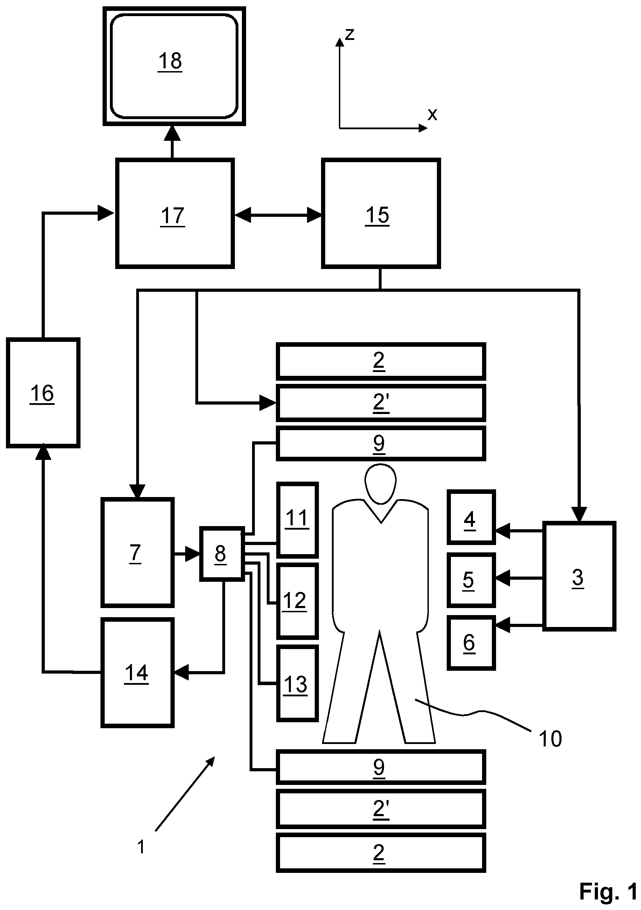

With reference to Fig. 1, an MR system 1 is shown as a block diagram. The device comprises superconducting or resistive main magnet coils 2 such that a substantially uniform, temporally constant main magnetic field $B_0$ is created along a z-axis through an examination volume. The device further comprises a set of (1st, 2nd, and - where applicable - 3rd order) shimming coils 2', wherein the current flow through the individual shimming coils of the set 2' is controllable for the purpose of minimizing $B_0$ deviations within the examination volume.

A magnetic resonance generation and manipulation system applies a series of RF pulses and switched magnetic field gradients to invert, excite, refocus, and/or spatially and otherwise encode the magnetic resonance to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send/receive switch 8, to a RF body coil 9 to transmit RF pulses into the examination volume. A typical MR imaging sequence is composed of a packet of RF pulse segments of short duration which, together with any applied magnetic field gradients, achieve a selected manipulation of nuclear magnetic resonance. The RF pulses are used to manipulate magnetic resonance and select a portion of a body 10 positioned in the examination volume. The MR signals are also picked up by the RF body coil 9.

For generation of MR images of limited regions of the body 10, a set of local RF array coils 11, 12, 13 are placed contiguous to the region selected for imaging. The array coils 11, 12, 13 can be used to receive MR signals induced by transmissions of the RF body coil.

The resultant MR signals are picked up by the RF body coil 9 and/or by the RF array coils 11, 12, 13 and demodulated by a receiver 14 preferably including a preamplifier (not shown). The receiver 14 is connected to the RF coils 9, 11, 12 and 13 via the send/receive switch 8.

A host computer 15 controls the shimming coils 2' as well as the gradient pulse amplifier 3 and the transmitter 7 to generate the imaging sequences of the invention. For the selected sequence, the receiver 14 receives MR signal data from a single or a plurality of k-space lines in rapid succession following each RF excitation pulse. A data acquisition system 16 performs analog-to-digital conversion of the received signals and converts the MR data to a digital format suitable for further processing. In modern MR systems the data acquisition system 16 is a separate computer which is specialized in acquisition of raw image data.

Ultimately, the digital MR signal data are reconstructed into an image representation by a reconstruction processor 17 which applies a Fourier transform or other appropriate reconstruction algorithms, such as SENSE. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

The host computer 15 and the reconstruction processor 17 are arranged, by corresponding programming, to perform the method of the invention described herein above and in the following.

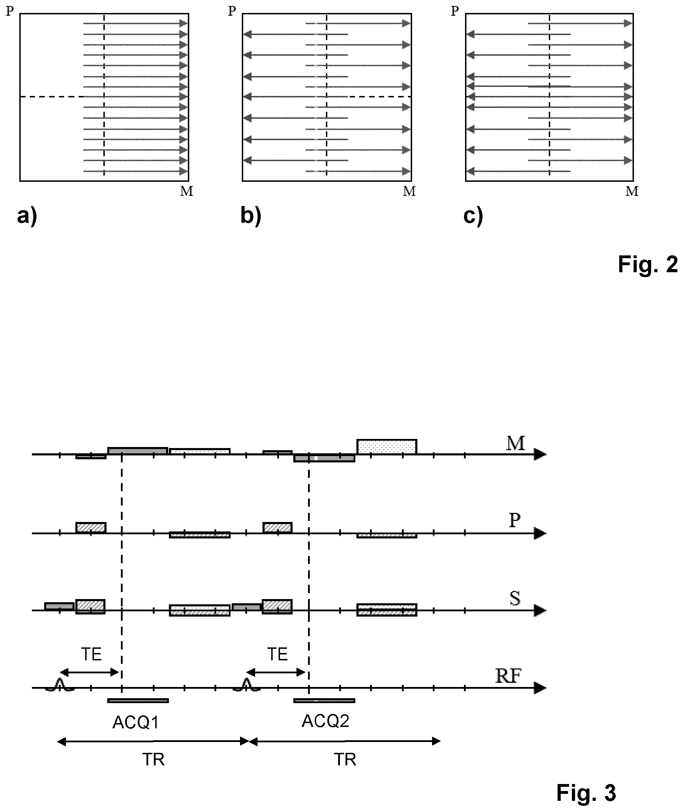

According to the invention, echo signals are acquired from the body 10 as partial echoes. Each partial echo represents a k-space line. This is illustrated in Figs. 2a,b,c. In the depicted two-dimensional k-space diagrams the readout direction is indicated by M and the phase-encoding direction by P. In conventional PE acquisition (Fig. 2a), the peripheral parts of k-space are covered in one direction, but not in the opposite direction. A large continuous k-space area is thus spared. To avoid the resulting poor conditioning of the MR image reconstruction, the direction in which the partial echoes are acquired is reversed during the scan according to the invention. This allows generating the alternative sampling patterns illustrated in Figs. 2b and 2c (among others). The PE acquisition is performed with different readout polarities, each echo signal being associated with either a first direction (to the right in Fig. 2) or a second direction (to the left in Fig. 2) which is opposite to the first direction, wherein the echo signals associated with the first and the second direction sample k-space sparsely in the phase-encoding direction P. In principle, the full k-space can be covered in this way, without prolonging TE, by performing the acquisition twice with opposite readout directions. In the example of Fig. 2b, the readout direction is reversed between adjacent k-space lines, resulting in two uniformly sparsely sampled data sets in the phase-encoding direction P. In the example of Fig. 2c, two non-uniformly sparsely sampled data sets in the phase-encoding direction are obtained. The k-space lines associated with the first and the second readout direction overlap in the central k-space part in the phase-encoding direction in the examples of Fig. 2b and 2c such that the central k-space part in the phase-encoding direction is fully sampled, i.e. not subsampled. This further improves the conditioning of the reconstruction. In Fig. 2c, the central k-space part in the frequency-encoding direction is also fully sampled.

A strategy to implement the sampling patterns shown in Figs. 2b and 2c efficiently is provided in Fig 3. The frequency-encoding direction is reversed after each repetition to cover k-space sequentially from bottom to top, for example.

Fig. 3 shows a pulse sequence diagram of a 3D spoiled partial gradient-echo sequence constituting an imaging sequence according to the invention. The diagram shows switched magnetic field gradients in the frequency-encoding direction M, the phase-encoding direction P, and the slice-selection direction S. Moreover, the diagram shows the RF excitation and refocusing pulses as well as the time intervals during which echo signals are acquired, designated by ACQ1 and ACQ2. One gradient echo is generated in each repetition time between successive RF excitations. The diagram covers the acquisition of the first two echo signals. In subsequent repetition times TR, the phase-encoding magnetic field gradients in the directions P and S are scaled to sample a pre-defined region of k-space. The two echo signals are generated at echo time TE. From the odd (left) to the even (right) repetitions, the polarity of the first two gradient lobes in the readout direction M is reversed, while the area of the third gradient lobe is adjusted in the even repetitions to preserve the steady-state spoiling regime. This does not necessarily lead to a longer TR, because a longer TR is often chosen anyway to optimize the signal-to-noise ratio (SNR).

In an alternative approach, the readout direction is reversed only once. The two sparsely sampled echo signal data sets are acquired serially in this case. While this allows disrupting the steady-state spoiling regime and keeping, except for the sign, the area of the third gradient lobe in the readout direction M, the two sparsely sampled echo signal data sets are potentially less consistent, for example in the presence of motion.

Reversing the readout direction of the partial echo signals during the scan causes the distortions induced by main magnetic field inhomogeneity to change direction. These distortions can be addressed by mapping the main magnetic field inhomogeneity in a separate measurement and by taking them into account in the reconstruction step. Alternatively, they can be estimated from the two sparsely sampled sets of echo signals, requiring a separate intermediate reconstruction of both and the application of a registration to the resulting images.

Moreover, reversing the readout direction of the partial echo signals during the scan potentially requires considering variations in linear and higher order gradient fields. This involves mapping a spatially or spatiotemporally varying phase difference between the echo signals acquired with opposite readout direction. This phase difference can also be estimated from the two sparsely sampled sets of echo signals.

The final reconstruction of the MR image from the acquired echo signals then solves the inverse problem corresponding to the model

$$\begin{bmatrix} \mathbf{y}_1 \\ \mathbf{y}_2 \end{bmatrix} = \begin{bmatrix} \mathbf{E}_1 \mathbf{D}_1 \mathbf{P}_1 \\ \mathbf{E}_2 \mathbf{D}_2 \mathbf{P}_2 \end{bmatrix} \mathbf{x},$$

wherein y denotes the two sparsely sampled sets of echo signals, E denotes the corresponding encoding matrices, D denotes the corresponding distortion matrices, P denotes the corresponding phase error matrices, and x denotes the image. Since the missing data is now always surrounded by available data in k-space, the conditioning of the inverse problem is much improved.

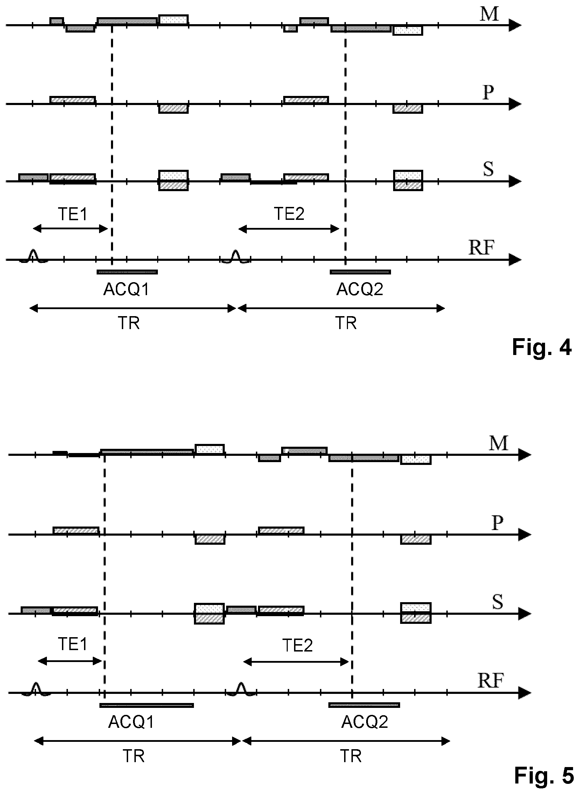

An example of dual-acquisition Dixon imaging with bipolar PE acquisition is shown in Fig. 4. The two sub-acquisitions with opposite polarities of the readout magnetic field gradient M are performed in series with different echo times TE1 and TE2 for chemical shift encoding. Depicted is one repetition from each sub-acquisition. The first (shorter) echo time TE1 is associated with the first readout gradient direction while the second (longer) echo time TE2 is associated with the second readout gradient direction. In the first repetition on the left, a dead time is introduced at the end. In the second repetition on the right, a dead time is introduced after the slab selection. For the sake of simplicity, flow compensation is applied only in the readout direction in the example.

Compared to conventional non-contrast-enhanced cerebral MRA with an opposed-phase TE, the dual-acquisition Dixon imaging sequence illustrated in Fig. 4 provides superior fat suppression and also reaches shorter TEs. However, the introduced dead times lead to a longer repetition time TR and a lower scan efficiency, defined as the ratio of the duration of the acquisition window ACQ1 and ACQ2 and TR. To remedy this, i.e. to improve on the scan efficiency, two different strategies may be applied to the two sub-acquisitions, as illustrated in Fig. 5, which shows a serial dual-acquisition Dixon imaging sequence with individually optimized, bipolar PE acquisition. In the first repetition on the left, the readout magnetic field gradient and the acquisition window ACQ1 are extended at the end, and the spoiler and rewinder magnetic field gradients are shifted. Moreover, the strength of the readout magnetic field gradient is reduced. This leads to a smaller PEF close to 0.5 (with the PEF indicating the fraction of k-space sampled by the PE relative to the full k-space), which is feasible in combination with the bipolar PE acquisition according to the invention, since a fully sampled central k-space is not required anymore for performing phase corrections. In the second repetition on the right, the readout magnetic field gradient and the acquisition window are extended in the front, and the phase-encoding gradients are shifted. This leads to a larger PEF. Preferably, TE1 of the first sub-acquisition is chosen more out-of-phase (with regard to the relative phase of water and fat signals) than TE2 of the second sub-acquisition. In this way, flow-induced signal loss between the first and the second sub-acquisition due to the longer TE is less likely to be misconstrued as water-fat dephasing.

The two sub-acquisitions in the above embodiments may be performed in series. Since the spoiling is disrupted once at the transition from the first to the second sub-acquisition, some additional repetition time intervals may be inserted at this transition to re-establish the spoiling. This causes only a marginal increase in scan time.

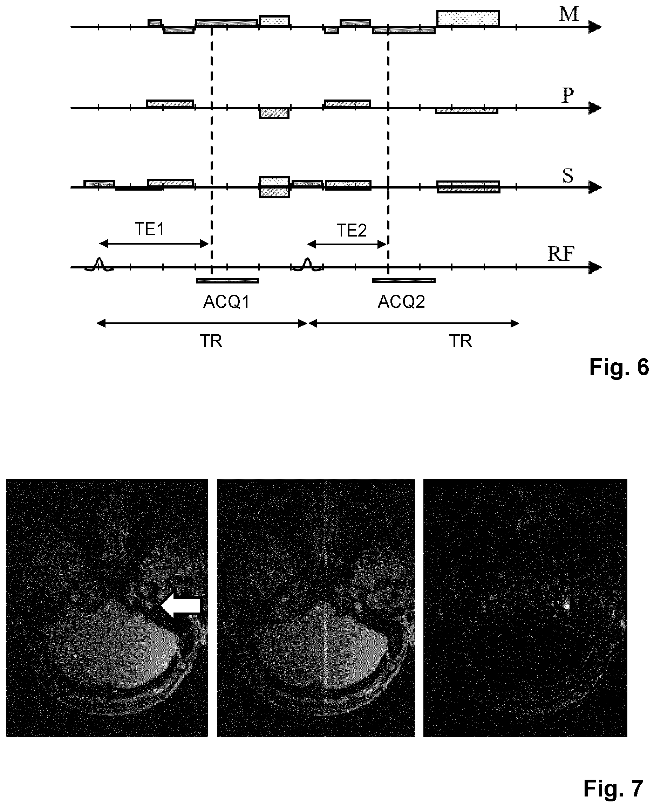

Alternatively, it may be advantageous to interleave the two sub-acquisitions, for instance by switching between them after each repetition. The integral of the magnetic field gradients in the readout direction M has to remain constant in this case, which requires the area of the spoiler magnetic field gradient in the readout direction M to be increased in one of the sub-acquisitions, as illustrated in Fig. 6, which shows an interleaved dual-acquisition Dixon imaging sequence with bipolar partial echo acquisition and optimized allocation of the two echo times TE1 and TE2 to the two polarities of the readout magnetic field gradient. Preferably, the area of the spoiler readout magnetic field gradient is increased in the sub-acquisition with the shorter echo time, in this case TE2, to optimize the scan efficiency.

Furthermore, an example outside the scope of the present invention proposes to (approximately) compensate for undesirable signal loss in PF imaging arising from rapid variations of the phase in image space, which has the potential to result in misdiagnoses. The acquired echo signals are first shifted by different extents in k-space according to a number of shift values and a weighting is then applied to them. For each shift value, a separate intermediate reconstruction is then performed, and the maximum signal intensity is selected per voxel over all resulting intermediate MR images. Mathematically, the proposed PF reconstruction method may be described by

$$s(x) = max_p\{|F\{W(k)\,S(k+p)\}|\},$$

wherein S denotes the acquired echo signals, $W$ denotes the weighting, $F$ denotes a Fourier transform, p denotes a set of shift values, and s denotes the reconstructed final MR image. This example outside the scope of the present invention is illustrated with time-of-flight (TOF) MRA in Fig. 7, in which a selected slice from a three-dimensional axial partial echo acquisition, reconstructed from the echo signals from one channel of the employed head coil, is shown, once with a conventional PE method (left image) and once with the PF method proposed by the example (middle image), as well as their difference (right image). Using the conventional PF method with a simple weighting leads to the signal loss in the left interior carotid artery marked in the left image, which could easily be misconstrued as a stenosis. However, the PF method proposed by the example, with a set of 20 shift values in this example, successfully recovers the signal intensity in this vessel, and it turns out that there is indeed no indication of a stenosis.

**Claims**

1. Method of magnetic resonance, MR, imaging of an object (10) placed in an examination volume of an MR system (1), the method comprising the steps of:

   - subjecting the object (10) to an imaging sequence comprising a series of radiofrequency, RF, excitations, wherein an echo signal is generated in the presence of a readout magnetic field gradient in each repetition time interval between successive RF excitations, wherein phase-encoding magnetic field gradients (P, S) are switched in each repetition time interval to sample a pre-defined region of k-space;
   - acquiring the echo signals from the object (10) as partial echoes with different readout polarities, each echo signal being associated with either a first direction of the readout magnetic field gradient or a second direction of the readout magnetic field gradient which is opposite to the first direction; and
   - reconstructing an MR image from the acquired echo signals;

   characterized in that the echo signals associated with the first and/or the second direction sample k-space sparsely in at least one phase-encoding direction (P, S).

2. Method of claim **1,** wherein the echo signals associated with the first direction sample a sub-region of k-space that is not sampled by the echo signals associated with the second direction, and vice versa.

3. Method of claim 1 or 2, wherein the k-space regions sampled by the echo signals associated with the first and second directions, respectively, overlap in a central part of k-space.

4. Method of any one of claims 1-3, wherein the echo signals associated with the first and second directions, respectively, sample k-space in an interleaved pattern in the at least one phase-encoding direction.

5. Method of any one of claims **1-4,** wherein the echo signals associated with the first and second directions, taken in combination, sample k-space fully in a central part of k-space.

6. Method of any one of claims 1-5, wherein the reconstructing of the MR image from the acquired MR signals relies on sensitivity encoding, compressed sensing, or combinations thereof, instead of on the assumption of smooth phase variation across the MR image.

7. Method of any one of claims 1-6, further comprising the step of mapping the main magnetic field inhomogeneity, wherein the main magnetic field inhomogeneity is taken into account in the step of reconstructing the MR image.

8. Method of any one of claims 1-7, further comprising the step of mapping a spatially or spatiotemporally varying phase difference between the echo signals associated with the first and the second direction, respectively, in image space, wherein the phase difference is taken into account in the step of reconstructing the MR image.

9. Method of any one of claims 1-8, wherein a spoiler magnetic field gradient in the readout direction, applied after acquiring the echo signals, is adapted such that the integral area of the readout magnetic field gradient is the same for each repetition time interval for both the first and the second direction.

10. Method of any one of claims 1-9, wherein the echo signals are acquired at an echo time at which the signal contributions from water and from fat are approximately in quadrature, wherein the contributions from water and fat are separated in the step of reconstructing the MR image.

11. Method of any one of claims 1-9, wherein the echo signals are acquired at different echo times, each echo signal being associated with either a first echo time or a second echo time so that a chemical shift encoding is applied to the acquired echo signal, wherein contributions from water and fat are separated in the step of reconstructing the MR image.

12. Method of claim 11, wherein the strength of the readout magnetic field gradient applied during acquisition of the echo signals associated with the shorter echo time is smaller than the strength of the readout magnetic field gradient applied during acquisition of the echo signals associated with the longer echo time.

13. Method of any one of claims 9, 11 and 12, wherein the area of the spoiler readout magnetic field gradient associated with the shorter echo time is larger than the spoiler readout magnetic field gradient's area associated with the longer echo time.

14. MR system comprising at least one main magnet coil (2) for generating a uniform, static magnetic field $B_0$ within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17) for reconstructing MR images from the received MR signals, wherein the MR system (1) is configured to perform a method of any one of claims 1-13.

15. Computer program comprising instructions which, when the program is executed by a control unit (15) and/or a reconstruction unit (17) of an MR system (1), cause the MR system to carry out a method of any one of claims 1-13.

**Patentansprüche**

1. Verfahren zur Magnetresonanz-, MR-, Bildgebung eines Objekts (10), das in einem Untersuchungsvolumen eines MR-Systems (1) platziert ist, wobei das Verfahren die folgenden Schritte umfasst:

   - Unterziehen des Objekts (10) einer Bildgebungssequenz, die eine Reihe von Hochfrequenz-, RF-, Anregungen umfasst, wobei in jedem Wiederholungszeitintervall zwischen aufeinanderfolgenden RF-Anregungen in Gegenwart eines Auslesemagnetfeldgradienten ein Echosignal erzeugt wird, wobei in jedem Wiederholungszeitintervall Phasenkodierungsmagnetfeldgradienten (P, S) geschaltet werden, um einen vordefinierten Bereich des k-Raums abzutasten;
   - Erfassen der Echosignale von dem Objekt (10) als Teilechos mit unterschiedlichen Auslesepolaritäten, wobei jedes Echosignal entweder einer ersten Richtung des Auslesemagnetfeldgradienten oder einer zweiten Richtung des Auslesemagnetfeldgradienten zugeordnet ist, die der ersten Richtung entgegengesetzt ist; und
   - Rekonstruieren eines MR-Bildes aus den erfassten Echosignalen;

   **dadurch gekennzeichnet, dass** die Echosignale, die der Reifen der ersten und/oder der zweiten Richtung zugeordnet sind, den k-Raum spärlich in mindestens einer Phasenkodierungsrichtung (P, S) abtasten.

2. Verfahren nach Anspruch 1, wobei die Echosignale, die der ersten Richtung zugeordnet sind, einen Teilbereich des k-Raums abtasten, der von den Echosignalen, die der zweiten Richtung zugeordnet sind, nicht abgetastet wird, und umgekehrt.

3. Verfahren nach Anspruch 1 oder 2, wobei sich die jeweils durch die Echosignale der ersten und zweiten Richtung abgetasteten k-Raum-Bereiche in einem zentralen Teil des k-Raums überlappen.

4. Verfahren nach einem der Ansprüche 1-3, wobei die Echosignale, die jeweils der ersten und zweiten Richtung zugeordnet sind, den k-Raum in mindestens einer Phasenkodierungsrichtung in einem verschachtelten Muster abtasten.

5. Verfahren nach einem der Ansprüche 1-4, wobei die Echosignale, die der ersten und zweiten Richtung zugeordnet sind, in Kombination den k-Raum in einem zentralen Bereich des k-Raums vollständig abtasten.

6. Verfahren nach einem der Ansprüche 1-5, wobei das Rekonstruieren des MR-Bildes aus den erfassten MR-Signalen auf Sensitivitätskodierung, komprimierter Erfassung oder Kombinationen davon beruht, anstatt auf der Annahme einer gleichmäßigen Phasenvariation über das MR-Bild.

7. Verfahren nach einem der Ansprüche 1-6, weiter umfassend den Schritt des Abbildens der Hauptmagnetfeldinhomogenität, wobei die Hauptmagnetfeldinhomogenität im Schritt der Rekonstruktion des MR-Bildes berücksichtigt wird.

8. Verfahren nach einem der Ansprüche 1-7, weiter umfassend den Schritt des Abbildens einer räumlich oder raumzeitlich variierenden Phasendifferenz zwischen den Echosignalen, die jeweils der ersten und zweiten Richtung zugeordnet sind, im Bildraum, wobei die Phasendifferenz im Schritt der Rekonstruktion des MR-Bildes berücksichtigt wird.

9. Verfahren nach einem der Ansprüche 1-8, wobei ein nach dem Erfassen der Echosignale angelegter Spoiler-Magnetfeldgradient in Ausleserichtung so ausgelegt ist, dass die integrale Fläche des Auslesemagnetfeldgradienten für jedes Wiederholungszeitintervall sowohl in der ersten als auch in der zweiten Richtung gleich ist.

10. Verfahren nach einem der Ansprüche 1-9, wobei die Echosignale zu einer Echozeit erfasst werden, bei der die Signalbeiträge von Wasser und Fett annähernd in Quadratur sind, wobei die Beiträge von Wasser und Fett im Schritt der Rekonstruktion des MR-Bildes getrennt werden.

11. Verfahren nach einem der Ansprüche 1-9, wobei die Echosignale zu unterschiedlichen Echozeiten erfasst werden, wobei jedes Echosignal entweder einer ersten oder einer zweiten Echozeit zugeordnet ist, sodass eine chemische Verschiebungskodierung auf das erfasste Echosignal angewendet wird, wobei die Beiträge von Wasser und Fett im Schritt der Rekonstruktion des MR-Bildes getrennt sind.

12. Verfahren nach Anspruch 11, wobei die Stärke des während der Erfassung der Echosignale mit der kürzeren Echozeit angelegten Auslesemagnetfeldgradienten kleiner ist als die Stärke des während der Erfassung der Echosignale mit der längeren Echozeit angelegten Auslesemagnetfeldgradienten.

13. Verfahren nach einem der Ansprüche 9, 11 und 12, wobei die Fläche des der kürzeren Echozeit zugeordneten Magnetfeldgradienten der Spoilerauslesung größer ist als die Fläche des der längeren Echozeit zugeordneten Magnetfeldgradienten der Spoilerauslesung.

14. MR-System, das mindestens eine Hauptmagnetspule (2) zum Erzeugen eines gleichförmigen, statischen Magnetfelds $B_0$ innerhalb eines Untersuchungsvolumens, eine Anzahl an Gradientenspulen (4, 5, 6) zum Erzeugen geschalteter Magnetfeldgradienten in unterschiedlichen Raumrichtungen innerhalb des Untersuchungsvolumens, mindestens eine RF-Spule (9) zum Erzeugen von RF-Impulsen innerhalb des Untersuchungsvolumens und/oder zum Empfangen von MR-Signalen von einem im Untersuchungsvolumen positionierten Objekt (10), eine Steuereinheit (15) zum Steuern der zeitlichen Abfolge von RF-Impulsen und geschalteten Magnetfeldgradienten, und eine Rekonstruktionseinheit (17) zum Rekonstruieren von MR-Bildern aus den empfangenen MR-Signalen umfasst, wobei das MR-System (1) konfiguriert ist, um das Verfahren nach einem der Ansprüche 1-13 auszuführen.

15. Computerprogramm, das Anweisungen umfasst, die, wenn das Programm von einer Steuereinheit (15) und/oder einer Rekonstruktionseinheit (17) eines MR-Systems (1) ausgeführt wird, das MR-System dazu veranlassen, ein Verfahren nach einem der Ansprüche 1-13 auszuführen.

**Revendications**

1. Procédé d'imagerie par résonance magnétique, RM, d'un objet (10) placé dans un volume d'examen d'un système RM (1), le procédé comprenant les étapes suivantes :

   - la soumission de l'objet (10) à une séquence d'imagerie comprenant une série d'excitations de radiofréquences, RF, dans lequel un signal d'écho est généré en présence d'un gradient de champ magnétique de lecture dans chaque intervalle de temps de répétition entre des excitations RF successives, dans lequel les gradients de champ magnétique d'encodage de phase (P, S) sont commutés dans chaque intervalle de temps de répétition pour échantillonner une région prédéfinie de l'espace k ;

   - l'acquisition des signaux d'écho de l'objet (10) sous forme d'échos partiels avec différentes polarités de lecture, chaque signal d'écho étant associé soit à une première direction du gradient de champ magnétique de lecture, soit à une seconde direction du gradient de champ magnétique de lecture opposée à la première direction ; et
   - la reconstruction d'une image RM à partir des signaux RM acquis ;

   **caractérisé en ce que** les signaux d'écho associés à la première direction et/ou à la seconde direction échantillonne l'espace k de manière clairsemée dans au moins une direction d'encodage de phase (P, S).

2. Procédé selon la revendication 1, dans lequel les signaux d'écho associés à la première direction échantillonnent une sous-région de l'espace k qui n'est pas échantillonnée par les signaux d'écho associés à la seconde direction, et vice versa.

3. Procédé selon la revendication 1 ou 2, dans lequel les régions de l'espace k échantillonnées par les signaux d'écho associés respectivement à la première direction et à la seconde direction se chevauchent dans une partie centrale de l'espace k.

4. Procédé selon l'une quelconque des revendications 1-3, dans lequel les signaux d'écho associés respectivement à la première direction et à la seconde direction échantillonnent l'espace k selon un motif entrelacé dans l'au moins une direction d'encodage de phase.

5. Procédé selon l'une quelconque des revendications 1-4, dans lequel les signaux d'écho associés aux première et seconde directions, pris en combinaison, échantillonnent entièrement l'espace k dans une partie centrale de l'espace k.

6. Procédé selon l'une quelconque des revendications 1-5, dans lequel la reconstruction de l'image RM à partir des signaux RM acquis repose sur l'encodage de sensibilité, la détection compressée ou des combinaisons de ceux-ci, au lieu de l'hypothèse d'une variation de phase lisse à travers l'image RM.

7. Procédé selon l'une quelconque des revendications 1-6, comprenant en outre l'étape de cartographie de l'inhomogénéité du champ magnétique principal, dans lequel l'inhomogénéité du champ magnétique principal est prise en compte dans l'étape de reconstruction de l'image RM.

8. Procédé selon l'une quelconque des revendications 1-7, comprenant en outre l'étape de cartographie d'une différence de phase spatialement ou spatio-temporellement variable entre les signaux d'écho associés respectivement à la première direction et à la seconde direction dans l'espace image, dans lequel la différence de phase est prise en compte dans l'étape de reconstruction de l'image RM.

9. Procédé selon l'une quelconque des revendications 1-8, dans lequel un gradient de champ magnétique de spoiler dans la direction de lecture, appliqué après l'acquisition des signaux d'écho, est adapté de telle sorte que la surface intégrale du gradient de champ magnétique de lecture soit la même pour chaque intervalle de temps de répétition pour la première direction et la seconde direction.

10. Procédé selon l'une quelconque des revendications 1-9, dans lequel les signaux d'écho sont acquis à un temps d'écho auquel les contributions de signal de l'eau et de la graisse sont approximativement en quadrature, dans lequel les contributions de l'eau et de la graisse sont séparées à l'étape de reconstruction de l'image RM.

11. Procédé selon l'une quelconque des revendications 1-9, dans lequel les signaux d'écho sont acquis à différents temps d'écho, chaque signal d'écho étant associé soit à un premier temps d'écho, soit à un second temps d'écho, de sorte qu'un encodage de déplacement chimique soit appliqué au signal d'écho acquis, dans lequel les contributions de l'eau et de la graisse sont séparées à l'étape de reconstruction de l'image RM.

12. Procédé selon la revendication 11, dans lequel l'intensité du gradient de champ magnétique de lecture appliqué pendant l'acquisition des signaux d'écho associés au temps d'écho le plus court est inférieure à l'intensité du gradient de champ magnétique de lecture appliqué pendant l'acquisition des signaux d'écho associés au temps d'écho le plus long.

13. Procédé selon l'une quelconque des revendications 9, 11 et 12, dans lequel la surface du gradient de champ magnétique de lecture de spoiler associé au temps d'écho le plus court est plus grande que la surface du gradient de champ magnétique de lecture de spoiler associé au temps d'écho le plus long.

14. Dispositif RM comprenant au moins une bobine magnétique principale (2) pour générer un champ magnétique statique uniforme $B_0$ dans un volume d'examen, un certain nombre de bobines à gradient (4, 5, 6) pour générer des gradients de champ magnétique commuté dans différentes directions spatiales à l'intérieur du volume d'examen, au moins une bobine RF (9) pour générer des impulsions RF à l'intérieur du volume d'examen et/ou pour recevoir des signaux RM provenant d'un objet (10) positionné dans le volume d'examen, une unité de commande (15) pour commander la succession temporelle d'impulsions RF et de gradients de champ magnétique commuté, et une unité de reconstruction (17) pour reconstruire des images RM à partir des signaux RM reçus, dans lequel le dispositif RM (1) est agencé pour réaliser un procédé selon l'une quelconque des revendications 1-13.

15. Programme informatique comprenant des instructions qui, lorsque le programme est exécuté par une unité de commande (15) et/ou une unité de reconstruction (17) d'un système MR (1), amènent le système MR à réaliser un procédé selon l'une quelconque des revendications 1-13.

**Fig. 1**

**Fig. 2**

**Fig. 3**

M

P

S

TE1                    TE2

RF

ACQ1                   ACQ2

TR                     TR

Fig. 4

M

P

S

TE1                    TE2

RF

ACQ1                   ACQ2

TR                     TR

Fig. 5

Fig. 6

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **BYDDER M. et al.** Minimizing echo and repetition times in magnetic resonance imaging using a double half-echo k-space acquisition and low-rank reconstruction. *NMR IN BIOMEDICINE*, 2020, vol. 34 (4), 1-8

- **M. B. SCHEIDEGGER et al.** *in Magnetic Resonance Imaging*, 1991, vol. 9, 517-524